Europäisches Patentamt

European Patent Office

Office européen des brevets

(11) Veröffentlichungsnummer: **0 359 867**

**A1**

## (12) EUROPÄISCHE PATENTANMELDUNG

(21) Anmeldenummer: 88115726.7

(22) Anmeldetag: 23.09.88

(51) Int. Cl.5: **H05K 3/34 , B23K 3/06**

(43) Veröffentlichungstag der Anmeldung:
28.03.90 Patentblatt 90/13

(84) Benannte Vertragsstaaten:
AT BE CH DE ES FR GB GR IT LI LU NL SE

(71) Anmelder: **Siemens Aktiengesellschaft**
**Wittelsbacherplatz 2**
**D-8000 München 2(DE)**

(72) Erfinder: **Unbehauen, Ralph, Dipl.-Ing.**
**Bahnhofstrasse 72**
**D-8011 Baldham(DE)**

(54) Verfahren zum Herstellen von elektrischen Flachbaugruppen.

(57) Auf Baugruppen mit SMD-Bauelementen müssen je nach Bestückung Lötmittelflecke unterschiedlicher Konfiguration aufgebracht werden. Um diese Lötmittelflecke rüstfrei aufbringen zu können, wird das Lötmittel in Pulverform mittels eines Druckwerkzeugs (z. B. 4) in der Art eines Laserdruckers auf die Leiterplatte (8) übertragen. Anschließend wird das Lötmittel z. B. durch aufgesprühtes Flußmittel an der Leiterplatte (8) fixiert.

EP 0 359 867 A1

## Verfahren zum Herstellen von elektrischen Flachbaugruppen

Die Erfindung bezieht sich auf ein Verfahren zum Herstellen von elektrischen Flachbaugruppen, insbesondere von Baugruppen, die mit SMD-Bauelementen bestückt werden.

Derartige Bauelemente, die keine Anschlußbeinchen aufweisen, werden stumpf an die Leiterplatten angelötet. Zuvor wird die Leiterplatte entsprechend den Anschlußstellen mit Lötpaste gedruckt. Die Lötpaste wird mit Hilfe von Schablonen oder im Siebdruckverfahren aufgebracht. Beim anschließenden Erhitzen der Baugruppe werden die Bauelemente mit der Leiterplatte verlötet.

Derartige Schablonen oder Siebdruckvorlagen ermöglichen eine hohe Mengenleistung. Das Herstellen und Wechseln der Druckvorlagen ist jedoch mit beträchtlichem Kosten- und Zeitaufwand verbunden. Moderne Fertigungen sind auftragsorientiert. D. h. die Baugruppen werden so gefertigt, wie sie in Montage der elektronischen Anlagen benötigt werden. Das bedeutet, daß sich die Losgrößen erheblich verringern und der Umrüstaufwand erhöht.

Der Erfindung liegt die Aufgabe zugrunde, den Aufwand für das Auftragen von Lötmitteln auf die Leiterplatte insbesondere beim Wechsel der Baugruppentypen zu verringern.

Diese Aufgabe wird durch die Erfindung gemäß Anspruch 1 gelöst. Danach werden Schablonen oder Druckvorlagen vollkommen überflüssig. Das Druckwerkzeug kann z. B. fotoelektrisch aufgeladen und entsprechend mit Lötmittel versehen werden. Dies läßt sich schneller bewerkstelligen als das nachfolgende Bestücken der Leiterplatte. Das Druckwerkzeug kann ohne weiteres von Baugruppe zu Baugruppe unterschiedliche Druckbilder erzeugen, ohne daß dies mit einem zeitlichen Mehraufwand verbunden wäre. Das Lötmittel kann anschließend z. B. durch Wärmestrahlung vorübergehend angeschmolzen und fixiert werden. Es ist aber auch möglich, nach dem Aufbringen des Lötmittels über die Leiterplatte ein Bindemittel zu sprühen, daß zusammen mit dem Lötmittel einen pastenartigen Belag ergibt.

Vorteilhafte Weiterbildungen der Erfindung sind in den Ansprüchen 2 bis 4 gekennzeichnet:

Durch die Weiterbildung nach Anspruch 2 kann das Druckwerkzeug annähernd die Druckgeschwindigkeit eines Laserdruckers erreichen.

Durch die Weiterbildung nach Anspruch 3 wird das Flußmittel zugleich als Bindemittel genutzt.

Durch die Weiterbildung nach Anspruch 4 ist es möglich, die Vorrichtung kostengünstig mit Hilfe von Teilen eines Laserdruckers herzustellen. Dabei ist im wesentlichen die Papierführung durch eine Vorschubeinrichtung für die Leiterplatten zu ersetzen. Da für das Verlöten eine größere Menge an Lötmittel benötigt wird als dies bei Druckfarbe eines Laserdruckers erforderlich ist, muß auch die Einrichtung zum Auftragen des Lötmittels entsprechend abgeändert werden.

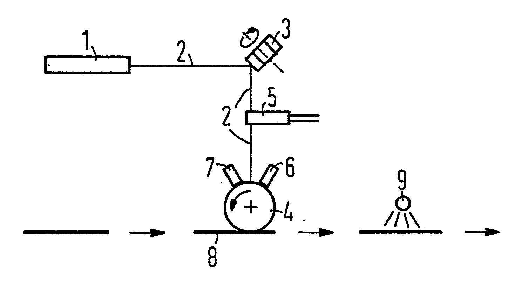

Im folgenden wird die Erfindung anhand eines in der Zeichnung dargestellten Ausführungsbeispieles näher erläutert.

Die dargestellte Figur zeigt schematisch einen Lasergenerator 1, der einen Laserstrahl 2 aussendet. Dieser trifft auf einen rotierbaren Polygonspiegel 3, von dem aus der Laserstrahl 2 um ungefähr 90° auf eine Druckwalze 4 umgelenkt wird. Zwischen der Druckwalze 4 und dem Polygonspiegel 3 ist ferner ein Strahlablenker 5 vorgesehen.

Die Druckwalze 4 ist entsprechend der Pfeilrichtung drehbar. Ihr ist eine elektrostatische Aufladung 6 zugeordnet, durch die ihre fotoelektrische Beschichtung vollflächig aufgeladen wird. Diese wird nachfolgend an den Stellen, die durch den Laserstrahl 2 belichtet werden, teilweise wieder entladen. Ein nachfolgend an der Druckwalze 4 angeordneter Pulverauftrag 7 bewirkt, daß pulverförmiges Lötmittel an den nichtentladenen Stellen der Druckwalze 4 haften bleibt. Auf der dem Laserstrahl 2 abgewandten Seite der Druckwalze 4 drückt sich diese gegen eine Leiterplatte 8, die mit gleicher Geschwindigkeit linear vorgeschoben wird. Dabei überträgt sich das Lötmittel auf die Leiterplatte 8. Diese wird entsprechend den waagrechten Pfeilen zu einem Flußmittelauftrag 9 weiter transportiert. Dieser besprüht die Leiterplatte 8 mit Flußmittel, wodurch das pulverförmige Lötmittel an der Leiterplatte 8 fixiert wird.

Bezugszeichenliste

1 Lasergenerator
2 Laserstrahl
3 Polygonspiegel
4 Druckwalze
5 Strahlablenker
6 Aufladung
7 Pulverauftrag
8 Leiterplatte
9 Flußmittelauftrag

## Ansprüche

1. Verfahren zum Herstellen von elektrischen Flachbaugruppen, insbesondere von mit SMD-Bauelementen bestückten Baugruppen, bei denen auf eine Leiterplatte (8) je nach Bestückung mit Bauelementen Lötmittelflecke in unterschiedlicher Konfiguration aufgebracht werden,

**dadurch gekennzeichnet,**

daß das Lötmittel in Pulverform auf ein entsprechend der jeweiligen Konfiguration elektrostatisch aufgeladenes Druckwerkzeug (z. B. 4) aufgebracht und auf die Leiterplatte (8) übertragen wird und daß danach das Lötmittel durch Wärme oder Zusatzstoffe an der Leiterplatte (8) fixiert wird.

2. Verfahren nach Anspruch 1,

**dadurch gekennzeichnet,**

daß als Druckwerkzeug eine Druckwalze (4) mit einer fotoelektrisch empfindlichen Beschichtung dient, die von einem gesteuerten Laserstrahl (2) beschrieben wird.

3. Verfahren nach Anspruch 1 oder 2,

**dadurch gekennzeichnet,**

daß als Zusatzstoff Flußmittel auf die Leiterplatte (8) aufgesprüht wird.

4. Vorrichtung zur Durchführung des Verfahrens nach Anspruch 1, 2 oder 3,

**dadurch gekennzeichnet,**

daß die Vorrichtung in der Art eines Laserdruckers ausgebildet ist und eine Einrichtung (z. B. 7) zum Auftragen des Lötmittels aufweist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| A | US-A-4 604 966 (KOHN) * Spalte 3, Zeile 14 - Spalte 6, Zeile 13; Figuren 1-8 * --- | 1,4 | H 05 K 3/34 B 23 K 3/06 |
| A | EP-A-0 168 374 (CENTRE DE RECHERCHES METALLURIQUES) * Seite 3, Zeile 16 - Seite 4, Zeile 8; Ansprüche 1-3; Figur 1 * ----- | 2,4 | |

RECHERCHIERTE SACHGEBIETE (Int. Cl.3)

H 05 K
B 23 K

Der vorliegende Recherchenbericht wurde für alle Patentansprüche erstellt

| Recherchenort | Abschlußdatum der Recherche | Prüfer |
|---|---|---|
| DEN HAAG | 12-05-1989 | HERBRETEAU D.J-P.J. |

EPO FORM 1503 03.82 (P0403)